# FASCICULE DE BREVET EUROPEEN

(11) **EP 1 710 805 B1**
(45) Date de publication et mention de la délivrance du brevet: **26.09.2007**
(21) Numéro de dépôt: 06290492.5
(22) Date de dépôt: 29.03.2006
(51) Int. Cl.: G11C 7/00

(54) **Dispositif de mémoire SRAM avec remise à zéro instantanée et procédé correspondant de remise à zéro instantanée**
SRAM-Speichervorrichtung mit sofortiger Nullrückstellung und entsprechendes Verfahren zur sofortigen Nullrückstellung
SRAM memory device with instantaneous reset and corresponding instantaneous reset procedure

(30) Priorité: 01.04.2005 FR 0503247
(43) Date de publication de la demande: 11.10.2006
(73) Titulaire: STMICROELECTRONICS SA, 92120 Montrouge (FR)
(72) Inventeur: Schoellkopf, Jean-Pierre, 38000 Grenoble (FR)
(74) Mandataire: Zapalowicz, Francis

(56) Documents cités:
- EP-A- 1 324 340
- US-A- 5 373 466
- US-A1- 2004 223 362

## Description

L'invention concerne les circuits intégrés et plus particulièrement les circuits intégrés semi-conducteur de mémoire.

L'invention concerne plus particulièrement une mémoire statique à accès aléatoire (mémoire SRAM) ayant une fonction de remise à zéro instantanée, communément désignée par l'homme du métier sous la dénomination anglo-saxonne de « flash clear ».

Certains types de mémoire classique SRAM incorporent la fonction de « flash clear » par laquelle toutes les cellules-mémoire sont mises à un instant donné dans un état donné (classiquement par exemple un zéro logique). La fonction de remise à zéro instantanée, activée en réponse à un signal de commande externe à la mémoire, permet d'initialiser la mémoire, par exemple pour une remise à zéro ou dans un but de test.

Classiquement, la remise à zéro instantanée de la mémoire est effectuée en sélectionnant simultanément toutes les lignes de mots (Word lines) de la matrice de cellules-mémoire, de façon à sélectionner toutes les cellules-mémoire, et en forçant toutes les lignes de bits (bits lines) de la matrice de cellule-mémoire à un potentiel de référence (typiquement à la masse). Ainsi, toutes les cellules-mémoire basculent dans leur état logique « zéro ».

La demande de brevet américain n° 2003/0231,538 décrit une autre solution pour implémenter une fonction de remise à zéro instantanée particulièrement simple à réaliser et à mettre en oeuvre dans les mémoires SRAM existantes pour lesquelles une fonction de remise à zéro n'a pas été prévue à l'origine.

Cependant, une telle solution augmente la surface du point mémoire car elle nécessite l'utilisation de deux commutateurs par colonne et de deux lignes d'alimentation différentes.

L'invention apporte une solution radicalement différente pour la réalisation de la fonction de remise à zéro instantanée (« flash clearing ») d'une mémoire statique.

Un but de l'invention est d'implémenter la fonction de remise à zéro instantanée sans nécessiter de surface additionnelle.

L'invention a également pour but de proposer une gestion de la commande de remise à zéro instantanée réalisée par un circuit de commande de faible complexité.

L'invention a encore pour but de pouvoir être appliquée à toute cellule-mémoire « rectangulaire » quelle que soit sa densité.

Selon un aspect de l'invention, il est proposé un dispositif de mémoire statique, comprenant au moins une cellule-mémoire à deux inverseurs CMOS couplés de façon croisée et destinés à être connectés entre une première tension, par exemple la masse, et une deuxième tension, par exemple la tension d'alimentation.

Selon une caractéristique générale de cet aspect de l'invention, le substrat du transistor NMOS d'un premier inverseur est électriquement isolé du substrat du transistor NMOS du deuxième inverseur, par exemple en utilisant une technologie triple caisson (« triple well », selon une dénomination anglo-saxonne habituellement utilisée par l'homme du métier).

Par ailleurs, les deux substrats sont aptes à être polarisés avec la première tension. Le dispositif de mémoire comprend des moyens de remise à zéro instantanée de la cellule aptes à porter temporairement à ladite deuxième tension la polarisation du substrat du transistor NMOS du premier inverseur.

En d'autres termes, l'invention prévoit avantageusement la remise à zéro instantanée de la cellule-mémoire en appliquant simplement une impulsion de tension sur le substrat de l'un des transistors NMOS de la cellule-mémoire. Cet aspect de l'invention est par ailleurs remarquable en ce sens que la majeure partie des moyens de remise à zéro instantanée est « enterrée » dans le substrat du circuit intégré et utilise certains moyens, tels que les substrats de transistors NMOS et prises de contact sur ces substrats, déjà présents dans une architecture de mémoire SRAM mais jusqu'à présent non employés à cette fin.

De ce fait la densité du point mémoire est quasiment inchangée.

Selon un mode de réalisation de l'invention, les moyens de remise à zéro instantanée comportent un inverseur de commande connecté à la prise substrat du transistor du premier inverseur et un plot de contact. Les moyens de remise à zéro instantanée comportent également des moyens de commande aptes à délivrer un signal logique à l'état bas sur le plot, de façon à porter temporairement à ladite deuxième tension la polarisation du substrat NMOS du premier inverseur.

Selon un mode de réalisation de l'invention, le transistor NMOS du premier inverseur est situé dans et sur un premier caisson semi-conducteur de type de conductivité P. Le transistor NMOS du deuxième inverseur est situé dans et sur un deuxième caisson semi-conducteur de type de conductivité P. Ces deux caissons P sont mutuellement isolés électriquement. Ils sont aptes à être polarisés à la première tension. Ils sont séparés par un caisson de type N apte à être polarisé à la deuxième tension. Les deux transistors PMOS des deux inverseurs sont réalisés dans ce caisson de type N. Les moyens de remise à zéro instantanés sont alors aptes à porter temporairement la polarisation du premier caisson à ladite deuxième tension.

L'inverseur de commande est avantageusement connecté entre le premier caisson et le plot de contact.

Selon un mode de réalisation de l'invention, le dispositif comprend une matrice de cellules-mémoire et les moyens de remise à zéro instantanée sont aptes à porter temporairement et simultanément à ladite deuxième tension, la polarisation des substrats des transistors NMOS des premiers inverseurs des cellules d'au moins une colonne de la matrice.

Ainsi, selon ce mode de réalisation, l'invention ne nécessite l'utilisation que d'un seul inverseur par colonne de la matrice.

L'invention s'applique avantageusement aux cellules-mémoire de structure rectangulaire. Plus particulièrement, selon un mode de réalisation du dispositif dans lequel il est prévu un ensemble de caissons semi-conducteurs parallèles présentant respectivement et alternativement des conductivités de type N et P. Les caissons de type N sont aptes à être polarisés à ladite deuxième tension et les caissons de type P sont aptes à être polarisés à ladite première tension. Un caisson N comporte les transistors PMOS d'une colonne de cellules de la matrice et les deux caissons P situés de part et d'autre du caisson N comportent respectivement les transistors NMOS des inverseurs de ladite colonne de cellules. Les moyens de remise à zéro sont alors aptes à porter à ladite deuxième tension la polarisation d'un caisson P sur deux d'au moins une partie du dispositif de mémoire.

Dans le cas où l'on souhaite remettre à zéro l'ensemble de la mémoire, les moyens de remise à zéro instantanée sont aptes à porter temporairement et simultanément à ladite deuxième tension la polarisation des substrats des transistors NMOS des premiers inverseurs des cellules de toutes les colonnes de la matrice.

Ainsi, dans ce cas, les moyens de remise à zéro sont avantageusement aptes à porter à la deuxième tension, la polarisation d'un caisson P sur deux du dispositif de mémoire.

Matériellement, les moyens de remise à zéro comportent avantageusement des inverseurs de commande respectivement connectés entre un caisson P sur deux et des plots de contact et des moyens de commande aptes à délivrer un signal logique à l'état bas sur au moins un plot, de façon à porter la polarisation du caisson P correspondant à ladite deuxième tension.

Les moyens de commande peuvent être aptes à délivrer le signal logique à l'état bas sur tous les plots, de façon à porter la polarisation d'un caisson P sur deux à ladite deuxième tension.

Selon un autre aspect de l'invention, il est également proposé un procédé de remise à zéro instantanée d'un dispositif de mémoire comprenant au moins une cellule-mémoire à deux inverseurs CMOS couplés de façon croisée et aux bornes desquels on applique une première tension et une deuxième tension.

Selon une caractéristique générale de cet autre aspect de l'invention, le substrat du transistor NMOS d'un premier inverseur est électriquement isolé du substrat du transistor NMOS du deuxième inverseur, les deux substrats sont polarisés avec la première tension et on porte temporairement à ladite deuxième tension la polarisation du substrat du transistor NMOS du premier inverseur.

Selon un mode de mise en oeuvre de l'invention dans lequel le transistor NMOS du premier inverseur est situé dans et sur un premier caisson semi-conducteur de type de conductivité P, le transistor NMOS du deuxième inverseur est situé dans et sur un deuxième caisson semi-conducteur de type de conductivité P, ces deux caissons P étant mutuellement isolés électriquement, polarisés à la première tension et séparés par un caisson de type N polarisé à la deuxième tension et dans et sur lequel sont réalisés les deux transistors PMOS des deux inverseurs, on porte temporairement la polarisation du premier caisson P à ladite deuxième tension.

Selon un mode de mise en oeuvre de l'invention dans lequel le dispositif comprend une matrice de cellules-mémoire, on porte temporairement et simultanément à ladite deuxième tension la polarisation des substrats des transistors NMOS des premiers inverseurs des cellules d'au moins une colonne de la matrice.

Selon un mode de mise en oeuvre de l'invention dans lequel le dispositif comprend un ensemble de caissons semi-conducteurs parallèles respectivement et alternativement de type N et P, les caissons de type N étant polarisés à ladite deuxième tension et les caissons de type P étant polarisés à ladite première tension, un caisson N comportant les transistors PMOS d'une colonne de cellules de la matrice, et les deux caissons P situés de part et d'autre du caisson N comportant respectivement les transistors NMOS des inverseurs de ladite colonne de cellules, on porte à ladite deuxième tension la polarisation d'un caisson P sur deux d'au moins une partie du dispositif de mémoire.

On peut porter temporairement et simultanément à ladite deuxième tension la polarisation des substrats des transistors NMOS des premiers inverseurs des cellules de toutes les colonnes de la matrice.

En termes de caissons, on peut porter à la deuxième tension la polarisation d'un caisson P sur deux du dispositif de mémoire.

D'autres avantages et caractéristiques de l'invention apparaîtront à l'examen de la description détaillée de modes de réalisation et de mises en oeuvre, nullement limitatifs, et des dessins annexés sur lesquels :
- la figure 1 illustre de façon schématique un mode de réalisation d'une cellule-mémoire équipée de moyens de remise à zéro instantanée,
- les figures 2 et 3 sont une représentation schématique au niveau circuit intégré d'un mode de réalisation de cellule-mémoire selon l'invention,
- les figures 4 et 5 illustrent de façon schématique un mode de mise en oeuvre de l'invention, et,
- la figure 6 illustre schématiquement un autre mode de réalisation et de mise en oeuvre d'un dispositif selon l'invention.

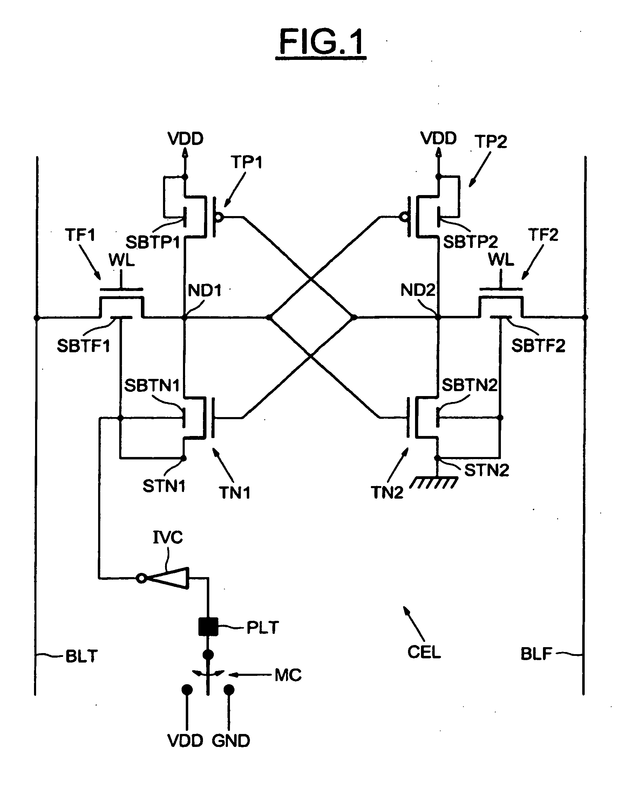

Sur la figure 1, la référence CEL désigne une cellule-mémoire du type SRAM à six transistors.

Plus précisément, la cellule-mémoire CEL comprend deux inverseurs CMOS couplés de façon croisée et connectés entre une première tension, ici la masse GND, et une deuxième tension, ici la tension d'alimentation VDD.

Le premier inverseur est formé d'un transistor NMOS TN1 et d'un transistor PMOS TP1.

Le deuxième inverseur est formé d'un transistor NMOS TN2 et d'un transistor PMOS TP2.

Le noeud commun ND1 au transistor NMOS TN1 et au transistor PMOS TP1 du premier inverseur est relié à une première ligne de bits BLT par l'intermédiaire d'un transistor de transfert TF1 dont la grille est reliée à une ligne de mots WL (word line).

De même, le noeud commun ND2 au transistor NMOS TN2 et au transistor PMOS TP2 du second inverseur est relié à la ligne de bits complémentaire BLF par l'intermédiaire d'un autre transistor de transfert TF2 dont la grille est également reliée à la ligne de mots WL.

Les substrats SBTP1 et SBTP2 des transistors PMOS TP1 et TP2 sont reliés aux sources respectives de ces transistors et de ce fait également à la tension d'alimentation VDD.

Le substrat SBTN1 du transistor NMOS TN1 est relié à sa source STN1 qui est par ailleurs reliée à la masse en fonctionnement normal, c'est-à-dire en dehors d'une remise à zéro instantanée (« flash clear »).

Il en est de même pour le substrat SBTN2 du transistor TN2 qui est relié à sa source STN2 elle-même reliée à la masse.

Par ailleurs, les substrats SBTF1 et SBTF2 des transistors de transfert TF1 et TF2 sont respectivement reliés aux prises substrats SBTN1 et SBTN2 des transistors TN1 et TN2.

Il est également prévu des moyens de commande MC, par exemple extérieurs au dispositif de mémoire, et aptes à délivrer pour une remise à zéro instantanée de la cellule, comme on le verra plus en détail ci-après, un signal logique à l'état bas sur un plot PLT du circuit intégré contenant la cellule-mémoire.

Ce plot PLT est connecté au substrat SBTN1 du transistor TN1 par l'intermédiaire d'un inverseur de commande IVC qui peut être avantageusement réalisé de façon intégrée au sein du circuit intégré.

En variante, cet inverseur de commande IVC pourrait faire partie d'un circuit de commande contenant les moyens de commande MC et disposé à l'extérieur du circuit intégré.

Les moyens de commande sont représentés schématiquement sur la figure 1 par un interrupteur commandé capable de relier le plot PLT soit à la masse GND soit à la tension d'alimentation VDD.

En fonctionnement normal de la cellule, la tension d'alimentation VDD est appliquée sur le plot PLT. De ce fait, la source du transistor TN1 et les substrats des transistors TN1 et TF1 sont portés à la masse.

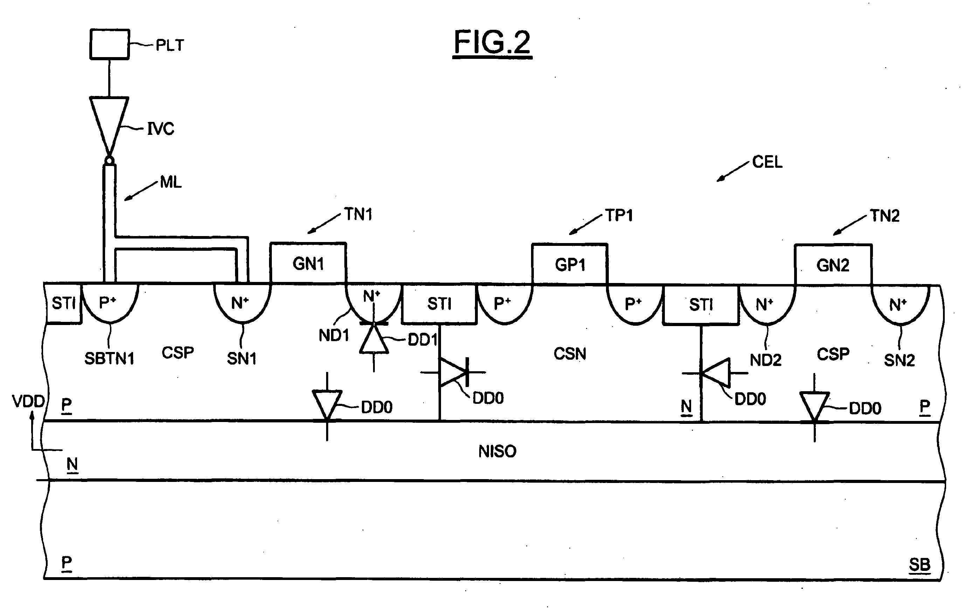

Le substrat du transistor NMOS TN1 est par ailleurs électriquement isolé du substrat du transistor NMOS TN2. Un exemple de réalisation d'une telle isolation est obtenu par une technologie dite triple caisson telle que celle illustrée à type d'exemple non limitatif sur la figure 2.

Plus précisément, au sein d'un substrat SB de type de conductivité P, est disposé un caisson enterré NISO de type de conductivité N.

Au-dessus de ce caisson NISO, se situent deux caissons CSP, ayant le type de conductivité P, séparés par un caisson CSN de type de conductivité N.

Les transistors NMOS TN1 et TF1 sont réalisés dans le caisson CSP situé sur la partie gauche de la figure 2 tandis que les transistors NMOS TN2 et TF2 sont réalisés dans le caisson CSP situé sur la partie droite de la figure 2.

Les deux transistors PMOS TP1 et TP2 sont réalisés dans le caisson CSN.

Sur la figure 2, à titre de simplification, n'ont été représentés schématiquement que les transistors TN1, TP1 et TP2.

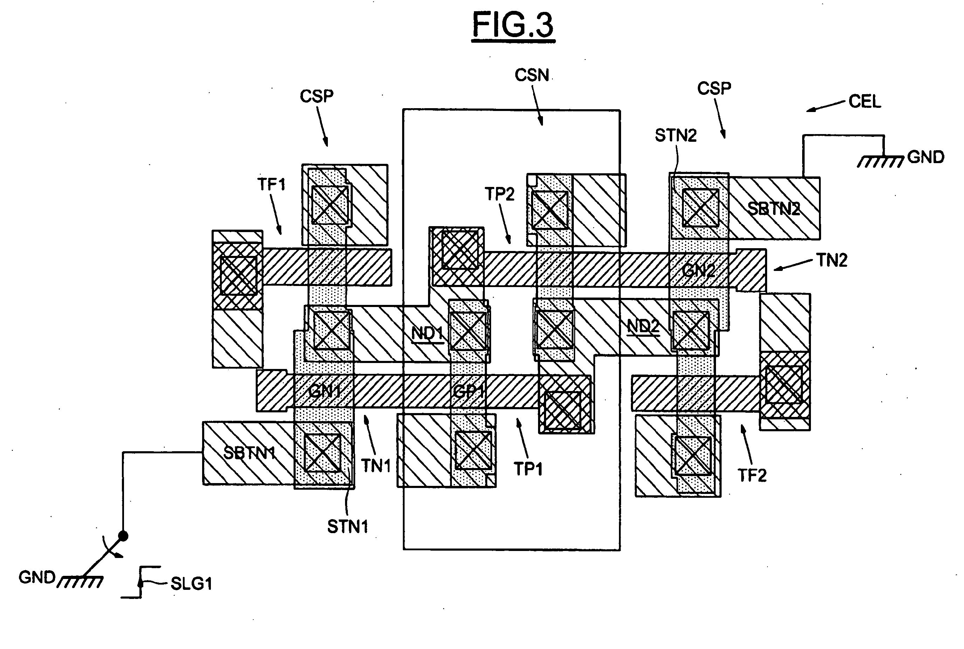

Par contre, l'ensemble de ces transistors ont été représentés au niveau schéma de placement (« layout ») sur la figure 3.

Le caisson NISO est porté à la tension d'alimentation VDD par l'intermédiaire d'une prise caisson non représentée sur la figure 2 à des fins de simplification. Il en est de même pour le caisson CSN.

Par ailleurs, les caissons CSP sont quant à eux portés à la masse, dans tous les cas en ce qui concerne le caisson CSP au sein duquel est réalisé le transistor TN2, et lors d'un fonctionnement de la mémoire distinct d'une remise à zéro instantanée, en ce qui concerne le caisson CSP dans lequel est réalisé le transistor TN1.

En conséquence, les deux caissons CSP sont mutuellement isolés par l'intermédiaire des différentes diodes PN référencées DDO.

Des moyens de liaison électriques formés par exemple de pistes métalliques et de vias relient l'inverseur IVC et le plot PLT aux zones surdopées SBTN1 et SN1.

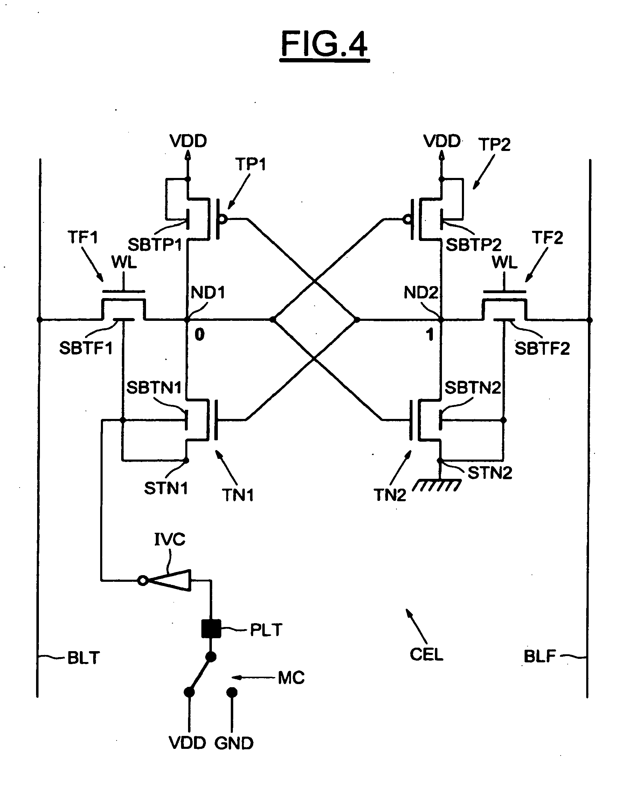

Supposons maintenant que la cellule-mémoire CEL soit programmée avec un « 1 » logique correspondant par exemple à la situation de la figure 4 sur laquelle le noeud ND1 est à la masse (état logique 0) alors que le noeud ND2 est porté à la tension d'alimentation VDD (état logique 1).

Ceci n'est qu'un exemple de convention et on pourrait bien entendu adopter une logique inverse.

Dans le cas de la figure 4, les substrats des transistors NMOS TN1 et TF1 sont portés à la masse, par exemple par l'application de la tension d'alimentation VDD sur le plot PLT.

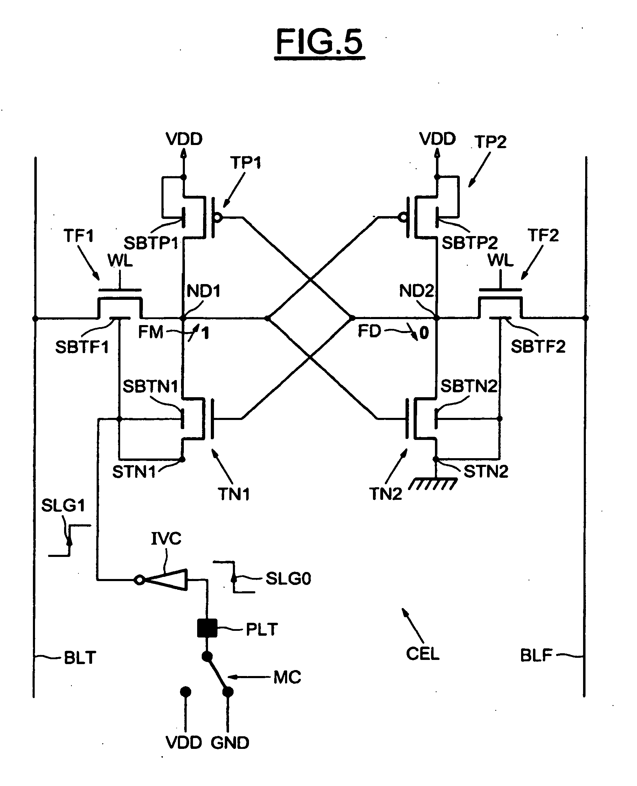

Lorsque l'on souhaite remettre à zéro instantanément la cellule-mémoire CEL, les moyens de commande MC appliquent, comme illustré sur la figure 5, un signal logique à l'état bas SLG0 sur le plot PLT. Par exemple, les moyens de commande appliquent la masse sur le plot PLT. De ce fait, un signal logique à l'état haut SLG1, par exemple, la tension d'alimentation, est alors appliqué sur la prise substrat SBTN1 ce qui a pour effet de rendre la diode DD1 (figure 2) passante et par conséquent de faire monter à 1 le noeud ND1 (flèche FM sur la figure 5).

Il en résulte alors une descente à zéro du noeud ND2 (flèche FD sur la figure 5). Et l'on se retrouve alors dans la configuration logique illustrée sur la figure 5 qui correspond effectivement à une cellule-mémoire CEL dans son état logique « 0 ».

Ainsi, dans cet exemple de réalisation et de mise en oeuvre, la remise à zéro instantanée de la cellule-mémoire a consisté simplement à porter temporairement à la tension d'alimentation la polarisation du substrat du transistor NMOS TN1 du premier inverseur formé des transistors TN1 et TP1, c'est-à-dire l'inverseur dont le noeud commun ND1 était initialement à l'état logique « 0 ».

Bien entendu, l'homme du métier saura ajuster la durée minimum nécessaire pour l'application de la tension d'alimentation sur le substrat du transistor NMOS TN1 de façon à permettre la montée à « 1 » du noeud ND1. A titre indicatif, une telle durée peut être de l'ordre de 1 nanoseconde.

Et, à l'issue de cette durée, la masse est de nouveau appliquée sur le substrat du transistor TN1 et du transistor TF1.

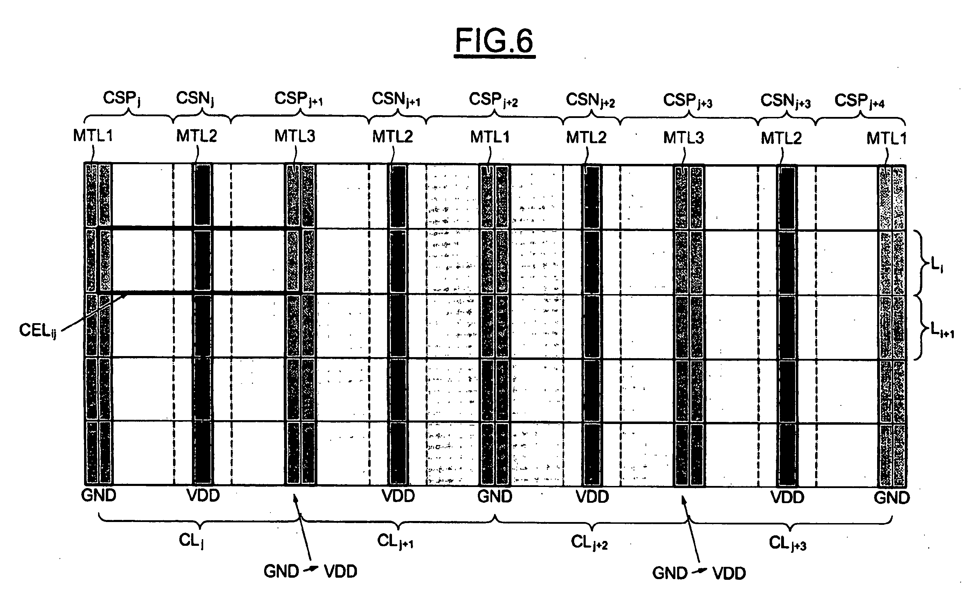

On se réfère maintenant plus particulièrement à la figure 6 qui illustre partiellement et schématiquement un dispositif de mémoire comprenant une matrice de cellules-mémoire CELᵢⱼ.

Cette matrice est formée de lignes Lᵢ et de colonnes CLⱼ.

Par ailleurs, sur la figure 6, le dispositif de mémoire comporte un ensemble de caissons semi-conducteurs parallèles respectivement et alternativement de type N et P.

Ainsi, les transistors PMOS de la cellule CELᵢⱼ sont réalisés dans le caisson CSN, tandis que le transistor TN1 du premier inverseur de cette cellule ainsi que le transistor du transfert TF1 sont réalisés dans le caisson CSPⱼ et que le transistor TN2 du deuxième inverseur de la cellule CELᵢⱼ et le transistor de transfert TF2 sont réalisés dans le caisson CSPⱼ₊₁.

Le caisson CSPⱼ₊₁ permet également la réalisation des transistors TN2 et TF2 de la cellule adjacente à la cellule CELᵢⱼ et située dans la colonne Clⱼ₊₁.

Des métallisations communes de colonne MTL2 permettent de polariser les différents caissons CSN à la tension d'alimentation VDD.

Des métallisations communes MTL1 disposées sur un caisson CSP sur deux permettent de polariser ces caissons à la masse GND.

Par ailleurs, des métallisations MTL3 sont disposées sur les autres caissons CSP de façon à pouvoir polariser ces caissons CSP soit à la masse GND soit à la tension d'alimentation VDD lorsque l'on souhaite effectuer une remise à zéro de toutes les cellules de la colonne considérée.

Ainsi, l'invention est remarquablement simple en ce sens qu'elle nécessite simplement l'utilisation d'un seul inverseur de commande par colonne ce qui permet de simultanément remettre à zéro de façon instantanée toutes les cellules d'une colonne.

Bien entendu, on peut remettre à zéro les cellules de certaines colonnes simplement ou bien remettre à zéro l'ensemble de la mémoire ce qui revient alors à porter temporairement à la tension d'alimentation VDD un caisson CSP sur deux.

## Revendications

1. Dispositif de mémoire statique, comprenant au moins une cellule-mémoire (CEL) à deux inverseurs CMOS couplés de façon croisée et destinés à être connectés entre une première tension et une deuxième tension, **caractérisé par le fait que** le substrat du transistor NMOS (TN1) d'un premier inverseur est électriquement isolé du substrat du transistor NMOS (TN2) du deuxième inverseur, les deux substrats étant aptes à être polarisés avec la première tension (GND), et **par le fait qu'**il comprend des moyens (MC, IVC) de remise à zéro instantanée de la cellule aptes à porter temporairement à ladite deuxième tension (VDD) la polarisation du substrat du transistor NMOS (TN1) du premier inverseur.

2. Dispositif selon la revendication 1, **caractérisé par le fait que** les moyens de remise à zéro instantanée comportent un inverseur de commande (IVC) connecté à la prise substrat du transistor du premier inverseur et un plot de contact (PLT), et des moyens de commande (MC) aptes délivrer un signal logique à l'état bas sur le plot, de façon à porter temporairement à ladite deuxième tension la polarisation du substrat du transistor NMOS du premier inverseur.

3. Dispositif selon la revendication 1 ou 2, **caractérisé par le fait que** le transistor NMOS (TN1) du premier inverseur est situé dans et sur un premier caisson semi-conducteur de type de conductivité P (CSP), **par le fait que** le transistor NMOS (TN2) du deuxième inverseur est situé dans et sur un deuxième caisson semi-conducteur de type de conductivité P (CSP), ces deux caissons P étant mutuellement isolés électriquement, aptes à être polarisés à la première tension et séparés par un caisson de type N (CSN) apte à être polarisé à la deuxième tension et dans et sur lequel sont réalisés les deux transistors PMOS des deux inverseurs, et **par le fait que** les moyens de remise à zéro instantanée sont aptes à porter temporairement la polarisation du premier caisson P à ladite deuxième tension.

4. Dispositif selon les revendications 2 et 3, **caractérisé par le fait que** l'inverseur de commande (IVC) est connecté entre le premier caisson et le plot de contact.

5. Dispositif selon l'une des revendications précédentes, **caractérisé par le fait qu'**il comprend une matrice de cellules-mémoire (CECᵢⱼ), et **par le fait que** les moyens de remise à zéro instantanée sont aptes à porter temporairement et simultanément à ladite deuxième tension la polarisation des substrats des transistors NMOS des premiers inverseurs des cellules d'au moins une colonne de la matrice.

6. Dispositif selon la revendication 5, **caractérisé par le fait qu'**il comprend un ensemble de caissons semi-conducteurs parallèles présentant respectivement et alternativement de type N et P, les caissons de type N étant aptes à être polarisés à ladite deuxième tension et les caissons de type P étant aptes à être polarisés à ladite première tension, un caisson N comportant les transistors PMOS d'une colonne de cellules de la matrice, et les deux caissons P situés de part et d'autre du caisson N comportant respectivement les transistors NMOS des inverseurs de ladite colonne de cellules, et **par le fait que** les moyens de remise à zéro sont aptes à porter à ladite deuxième tension la polarisation d'un caisson P sur deux d'au moins une partie du dispositif de mémoire.

7. Dispositif selon la revendication 5 ou 6, **caractérisé par le fait que** les moyens de remise à zéro instantanée sont aptes à porter temporairement et simultanément à ladite deuxième tension la polarisation des substrats des transistors NMOS des premiers inverseurs des cellules de toutes les colonnes de la matrice.

8. Dispositif selon la revendication 6, **caractérisé par le fait que** les moyens de remise à zéro sont aptes à porter à la deuxième tension la polarisation d'un caisson P sur deux du dispositif de mémoire.

9. Dispositif selon la revendication 6 ou 8, **caractérisé par le fait que** les moyens de remise à zéro comportent des inverseurs de commande respectivement connectés entre un caisson P sur deux et des plots de contacts, et des moyens de commande aptes à délivrer un signal logique à l'état bas sur au moins un plot, de façon à polariser le caisson P correspondant à ladite deuxième tension.

10. Dispositif selon la revendication 9, **caractérisé par le fait que** les moyens de commande sont aptes à délivrer le signal logique à l'état bas sur tous les plots, de façon à polariser un caisson P sur deux à ladite deuxième tension.

11. Procédé de remise à zéro instantanée d'un dispositif de mémoire comprenant au moins une cellule-mémoire à deux inverseurs CMOS couplés de façon croisée et aux bornes desquels on applique une première tension et une deuxième tension, **caractérisé par le fait que** le substrat du transistor NMOS d'un premier inverseur étant électriquement isolé du substrat du transistor NMOS du deuxième inverseur, les deux substrats étant polarisés avec la première tension, on porte temporairement à ladite deuxième tension la polarisation du substrat du transistor NMOS du premier inverseur.

12. Procédé selon la revendication 11, **caractérisé par le fait que** le transistor NMOS du premier inverseur est situé dans et sur un premier caisson semi-conducteur de type de conductivité P, **par le fait que** le transistor NMOS du deuxième inverseur est situé dans et sur un deuxième caisson semi-conducteur de type de conductivité P, ces deux caissons P étant mutuellement isolés électriquement, polarisés à la première tension et séparés par un caisson de type N polarisé à la deuxième tension et dans et sur lequel sont réalisés les deux transistors PMOS des deux inverseurs, et **par le fait qu'**on porte temporairement la polarisation du premier caisson P à ladite deuxième tension.

13. Procédé selon la revendication 11 ou 12, **caractérisé par le fait que** le dispositif comprend une matrice de cellules-mémoire, et **par le fait qu'**on porte temporairement et simultanément à ladite deuxième tension la polarisation des substrats des transistors NMOS des premiers inverseurs des cellules d'au moins une colonne de la matrice.

14. Procédé selon la revendication 13, **caractérisé par le fait que** le dispositif comprend un ensemble de caissons semi-conducteurs parallèles respectivement et alternativement de type N et P, les caissons de type N étant polarisés à ladite deuxième tension et les caissons de type P étant polarisés à ladite première tension, un caisson N comportant les transistors PMOS d'une colonne de cellules de la matrice, et les deux caissons P situés de part et d'autre du caisson N comportant respectivement les transistors NMOS des inverseurs de ladite colonne de cellules, et **par le fait qu'**on porte à ladite deuxième tension la polarisation d'un caisson P sur deux d'au moins une partie du dispositif de mémoire.

15. Procédé selon la revendication 13 ou 14, **caractérisé par le fait qu'**on porte temporairement et simultanément à ladite deuxième tension la polarisation des substrats des transistors NMOS des premiers inverseurs des cellules de toutes les colonnes de la matrice.

16. Procédé selon la revendication 14 ou 15, **caractérisé par le fait qu'**on porte à la deuxième tension la polarisation d'un caisson P sur deux du dispositif de mémoire.

## Claims

1. Static memory device comprising at least one memory cell (CEL) with two cross-coupled CMOS inverters intended to be connected to a first voltage and a second voltage, **characterized in that** the substrate of the NMOS transistor (TN1) of a first inverter is electrically insulated from the substrate of the NMOS transistor (TN2) of the second inverter and the two substrates can be biased with the first voltage (GND), and **in that** it comprises means (MC, IVC) for flash clearing the cell, which can temporarily bring the bias of the substrate of the NMOS transistor (TN1) of the first inverter to the said second voltage (VDD).

2. Device according to Claim 1, **characterized in that** the flash clearing means include a control inverter (IVC) connected to the substrate connection of the transistor of the first inverter and a contact pin (PLT), and control means (MC) which can deliver a logic signal in the low state to the pin so as to temporarily bring the bias of the substrate of the NMOS transistor of the first inverter to the said second voltage.

3. Device according to Claim 1 or 2, **characterized in that** the NMOS transistor (TN1) of the first inverter lies in or on a first semiconductor well with p-type conductivity (CSP), **in that** the NMOS transistor (TN2) of the second inverter lies in or on a second semiconductor well with p-type conductivity (CSP), these two p-type wells being electrically insulated from each other, can be biased to the first voltage and are separated by an n-type well (CSN), which can be biased to the second voltage and in or on which the two PMOS transistors of the two inverters are formed, and **in that** the flash clearing means can temporarily bring the bias of the first p-type well to the said second voltage.

4. Device according to Claims 2 and 3, **characterized in that** the control inverter (IVC) is connected between the first well and the contact pin.

5. Device according to one of the preceding claims, **characterized in that** it comprises a matrix of memory cells (CELᵢⱼ), and **in that** the flash clearing means can temporarily and simultaneously bring the bias of the substrates of the NMOS transistors of the first inverters of the cells of at least one column of the matrix to the said second voltage.

6. Device according to Claim 5, **characterized in that** it comprises a set of parallel semiconductor wells respectively and alternately of the n and p types, the n-type wells can be biased to the said second voltage and the p-type wells can be biased to the said first voltage, an n-type well including the PMOS transistors of a column of cells of the matrix and the two p-type wells, lying on either side of the n-type well, respectively including the NMOS transistors of the inverters of the said column of cells, and **in that** the clearing means can bring the bias of one in two p-type wells of at least a part of the memory device to the said second voltage.

7. Device according to Claim 5 or 6, **characterized in that** the flash clearing means can temporarily and simultaneously bring the bias of the substrates of the NMOS transistors of the first inverters of the cells of all the columns of the matrix to the said second voltage.

8. Device according to Claim 6, **characterized in that** the clearing means can bring the bias of one in two p-type wells of the memory device to the said second voltage.

9. Device according to Claim 6 or 8, **characterized in that** the clearing means include control inverters respectively connected between one in two p-type wells and contact pins, and control means which can deliver a logic signal in the low state to at least one pin so as to bias the corresponding p-type well to the said second voltage.

10. Device according to Claim 9, **characterized in that** the control means can deliver the logic signal in the low state to all the pins, so as to bias one in two p-type wells to the said second voltage.

11. Method for flash clearing a memory device comprising at least one memory cell with two cross-coupled CMOS inverters, to the terminals of which a first voltage and a second voltage are applied, **characterized in that**, the substrate of the NMOS transistor of a first inverter being electrically insulated from the substrate of the NMOS transistor of the second inverter and the two substrates being biased with the first voltage, the bias of the substrate of the NMOS transistor of the first inverter is temporarily brought to the said second voltage.

12. Method according to Claim 11, **characterized in that** the NMOS transistor of the first inverter lies in or on a first semiconductor well with p-type conductivity, **in that** the NMOS transistor of the second inverter lies in or on a second semiconductor well with p-type conductivity, these two p-type wells being electrically insulated from each other, biased to the first voltage and separated by an n-type well, which is biased to the second voltage and in or on which the two PMOS transistors of the two inverters are formed, and **in that** the bias of the first p-type well is temporarily brought to the said second voltage.

13. Method according to Claim 11 or 12, **characterized in that** the device comprises a matrix of memory cells, and **in that** the bias of the substrates of the NMOS transistors of the first inverters of the cells of at least one column of the matrix are temporarily and simultaneously brought to the said second voltage.

14. Method according to Claim 13, **characterized in that** the device comprises a set of parallel semiconductor wells respectively and alternately of the n and p types, the n-type wells being biased to the said second voltage and the p-type wells being biased to the said first voltage, an n-type well including the PMOS transistors of a column of cells of the matrix and the two p-type wells, lying on either side of the n-type well, respectively including the NMOS transistors of the inverters of the said column of cells, and **in that** the bias of one in two p-type wells of at least a part of the memory device is brought to the said second voltage.

15. Method according to Claim 13 or 14, **characterized in that** the bias of the substrates of the NMOS transistors of the first inverters of the cells of all the columns of the matrix are temporarily and simultaneously brought to the said second voltage.

16. Method according to Claim 14 or 15, **characterized in that** the bias of one in two p-type wells of the memory device is brought to the said second voltage.

## Patentansprüche

1. Statische Speichervorrichtung mit mindestens einer Speicherzelle (CEL) mit zwei kreuzweise gekoppelten CMOS-Invertern, die vorgesehen sind, zwischen einer ersten Spannung und einer zweiten Spannung angeschlossen zu werden, **dadurch gekennzeichnet, daß** das Substrat des NMOS-Transistors (TN1) eines ersten Inverters elektrisch von dem Substrat des NMOS-Transistors (TN2) des zweiten Inverters isoliert ist, wobei die zwei Substrate mit der ersten Spannung (GND) vorgespannt sein können, und **dadurch, daß** sie Einrichtungen (MC, IVC) zur sofortigen Nullrückstellung der Zelle aufweist, die die Vorspannung des Substrats des NMOS-Transistors (TN1) des ersten Inverters temporär auf die zweite Spannung (VDD) bringen können.

2. Vorrichtung nach Anspruch 1, **dadurch gekennzeichnet, daß** die Einrichtungen zur sofortigen Nullrückstellung einen Steuerinverter (IVC) aufweisen, der an dem Substratanschluß des Transistors des ersten Inverters angeschlossen ist, und einen Anschlußkontakt (PLT) aufweisen, und Steuereinrichtungen (MC) aufweisen, die ein Logiksignal niedrigen Zustands an den Kontakt ausgeben können, um die Vorspannung des Substrats des NMOS-Transistors des ersten Inverters temporär auf die zweite Spannung zu bringen.

3. Vorrichtung nach Anspruch 1 oder 2, **dadurch gekennzeichnet, daß** der NMOS-Transistor (TN1) des ersten Inverters in und auf einem ersten Halbleiterbereich des P-Leitungstyps (CSP) angeordnet ist, **dadurch, daß** der NMOS-Transistor (TN2) des zweiten Inverters in und auf einem zweiten Halbleiterbereich des P-Leitungstyps (CSP) angeordnet ist, wobei diese beiden P-Bereiche elektrisch voneinander isoliert sind, auf die erste Spannung vorgespannt werden können und durch einen Bereich des N-Typs (CSN) voneinander getrennt sind, der auf die zweite Spannung vorgespannt werden kann und in und auf welchem die zwei PMOS-Transistoren der zwei Inverter realisiert sind, und **dadurch**, daß die Einrichtungen zur sofortigen Nullrückstellung die Vorspannung des ersten P-Bereichs temporär auf die zweite Spannung bringen können.

4. Vorrichtung nach Anspruch 2 und Anspruch 3, **dadurch gekennzeichnet, daß** der Steuerinverter (IVC) zwischen dem ersten Bereich und dem Anschlußkontakt angeschlossen ist.

5. Vorrichtung nach einem der vorstehenden Ansprüche, **dadurch gekennzeichnet, daß** sie eine Matrix von Speicherzellen (CECᵢⱼ) aufweist, und **dadurch, daß** die Einrichtungen zur sofortigen Nullrückstellung die Vorspannung der Substrate der NMOS-Transistoren der ersten Inverter der Zellen mindestens einer Spalte der Matrix temporär und gleichzeitig auf die zweite Spannung bringen können.

6. Vorrichtung nach Anspruch 5, **dadurch gekennzeichnet, daß** sie mehrere parallele Halbleiterbereiche aufweist, die jeweils und abwechselnd vom N- und P-Typ sind, wobei die Bereiche des N-Typs auf die zweite Spannung vorgespannt werden können und die Bereiche des P-Typs auf die erste Spannung vorgespannt werden können, wobei ein N-Bereich die PMOS-Transistoren einer Spalte von Zellen der Matrix aufweist und die beiderseits des N-Bereichs angeordneten zwei P-Bereiche jeweils die NMOS-Transistoren der Inverter dieser Spalte von Zellen aufweisen, und **dadurch, daß** die Einrichtungen zur sofortigen Nullrückstellung die Vorspannung eines von zwei P-Bereichen mindestens eines Teils der Speichervorrichtung auf die zweite Spannung bringen können.

7. Vorrichtung nach Anspruch 5 oder 6, **dadurch gekennzeichnet, daß** die Einrichtungen zur sofortigen Nullrückstellung die Vorspannung der Substrate der NMOS-Transistoren der ersten Inverter der Zellen aller Spalten der Matrix temporär und gleichzeitig auf die zweite Spannung bringen können.

8. Vorrichtung nach Anspruch 6, **dadurch gekennzeichnet, daß** die Einrichtungen zur sofortigen Nullrückstellung die Vorspannung eines von zwei P-Bereichen der Speichervorrichtung auf die zweite Spannung bringen können.

9. Vorrichtung nach Anspruch 6 oder 8, **dadurch gekennzeichnet, daß** die Einrichtungen zur sofortigen Nullrückstellung Steuerinverter aufweisen, die jeweils zwischen einem von zwei P-Bereichen und den Anschlußkontakten angeschlossen sind, und die Steuereinrichtungen ein Logiksignal niedrigen Zustands an mindestens einen Kontakt ausgeben können, um den P-Bereich entsprechend der zweiten Spannung vorzuspannen.

10. Vorrichtung nach Anspruch 9, **dadurch gekennzeichnet, daß** die Steuereinrichtungen das Logiksignal niedrigen Zustands an alle Kontakte ausgeben können, um einen von zwei P-Bereichen auf die zweite Spannung zu bringen.

11. Verfahren zur sofortigen Nullrückstellung einer Speichervorrichtung, die mindestens eine Speicherzelle aus zwei kreuzweise gekoppelten CMOS-Invertern aufweist, an deren Anschlußklemmen eine erste Spannung und eine zweite Spannung angelegt wird, **dadurch gekennzeichnet, daß**, wobei das Substrat des NMOS-Transistors eines ersten Inverters elektrisch von dem Substrat des NMOS-Transistors des zweiten Inverters isoliert ist, wobei die zwei Substrate mit der ersten Spannung vorgespannt sind, die Vorspannung des Substrats des NMOS-Transistors des ersten Inverters temporär auf die zweite Spannung gebracht wird.

12. Verfahren nach Anspruch 11, **dadurch gekennzeichnet, daß** der NMOS-Transistor des ersten Inverters in und auf einem ersten Halbleiterbereich des P-Leitungstyps angeordnet ist, **dadurch, daß** der NMOS-Transistor des zweiten Inverters in und auf einem zweiten Halbleiterbereich des P-Leitungstyps angeordnet ist, wobei diese beiden P-Bereiche elektrisch voneinander isoliert sind, auf die erste Spannung vorgespannt sind und durch einen Bereich des N-Typs voneinander getrennt sind, der auf die zweite Spannung vorgespannt ist und in und auf welchem die zwei PMOS-Transistoren der zwei Inverter realisiert sind, und **dadurch**, daß die Vorspannung des ersten P-Bereichs temporär auf die zweite Spannung gebracht wird.

13. Verfahren nach Anspruch 11 oder 12, **dadurch gekennzeichnet, daß** die Vorrichtung eine Matrix von Speicherzellen aufweist, und **dadurch, daß** die Vorspannung der Substrate der NMOS-Transistoren der ersten Inverter der Zellen mindestens einer Spalte der Matrix temporär und gleichzeitig auf die zweite Spannung gebracht wird.

14. Verfahren nach Anspruch 13, **dadurch gekennzeichnet, daß** die Vorrichtung mehrere parallele Halbleiterbereiche jeweils und abwechselnd des N- und P-Typs aufweist, wobei die Bereiche des N-Typs auf die zweite Spannung vorgespannt sind und die Bereiche des P-Typs auf die erste Spannung vorgespannt sind, wobei ein N-Bereich die PMOS-Transistoren einer Spalte von Zellen der Matrix aufweist und die beiderseits des N-Bereichs angeordneten zwei P-Bereiche jeweils die NMOS-Transistoren der Inverter dieser Spalte von Zellen aufweisen, und **dadurch, daß** die Vorspannung eines von zwei P-Bereichen mindestens eines Teils der Speichervorrichtung auf die zweite Spannung gebracht wird.

15. Verfahren nach Anspruch 13 oder 14, **dadurch gekennzeichnet, daß** die Vorspannung der Substrate der NMOS-Transistoren der ersten Inverter der Zellen aller Spalten der Matrix temporär und gleichzeitig auf die zweite Spannung gebracht wird.

16. Verfahren nach Anspruch 14 oder 15, **dadurch gekennzeichnet, daß** die Vorspannung eines von zwei P-Bereichen der Speichervorrichtung auf die zweite Spannung gebracht wird.
